# FASCICULE DE BREVET EUROPEEN

(11) **EP 2 462 274 B1**
(45) Date de publication et mention de la délivrance du brevet: **05.10.2016**
(21) Numéro de dépôt: 10752409.2
(22) Date de dépôt: 09.08.2010
(51) Int. Cl.: D06M 11/83, D06M 11/84, D06M 10/06, A41D 31/00, C23C 14/20, A41D 13/002, D06M 101/32

(54) **PROCÉDÉ D'ÉLABORATION D'UN TISSU MÉTALLISE ET TISSU OBTENU**
VERFAHREN ZUR HERSTELLUNG EINES METALLISIERTEN GEWEBES UND ERHALTENES GEWEBE
METHOD FOR PRODUCING A METALLISED FABRIC, AND RESULTING FABRIC

(30) Priorité: 07.08.2009 FR 0903899
(43) Date de publication de la demande: 13.06.2012
(73) Titulaire: Brunswick Et Fils, 75002 Paris (FR)
(72) Inventeur: BRUNSWICK, Jean-Claude, F-33000 Bordeaux (FR)
(74) Mandataire: Cabinet Armengaud Aîné
(86) Numéro de dépôt international: PCT/IB2010/053587
(87) Numéro de publication internationale: WO 2011/016015

(56) Documents cités:
- JP-A- 62 284 075
- US-A- 4 657 807
- US-A1- 2008 057 191

## Description

La présente invention est relative à un procédé d'élaboration d'un tissu métallisé et à tout type de tissu susceptible d'être obtenu par l'application d'un tel procédé.

Les tissus métallisés ont de nombreuses applications, en particulier dans le domaine des vêtements de protection et des dispositifs dits réflecteurs d'infrarouges faisant barrière à la chaleur.

Dans un contexte de recherche d'économies d'énergies, les dispositifs réflecteurs d'infrarouges tels que rideaux ou stores présentent un grand intérêt dans la mesure où ils permettent de limiter les pertes thermiques en hiver aux niveaux des fenêtres de locaux et protéger en été contre la chaleur

Les solutions existantes comprennent, généralement, l'association d'un support en tissu et d'un film métallique par collage.

Le matériau ainsi réalisé présente cependant l'inconvénient d'être peu flexible et se caractérise par un aspect désagréable au toucher.

US 2008/057191 divulgue un procédé d'élaboration d'un tissu métallisé, comprenant une étape de lavage d'un substrat tissé, une étape de calandrage du substrat par l'application d'un effort de compression sur le substrat et une étape de métallisation du substrat, par dépôt autocatalytique de particules métalliques de manière à former une couche de métal sur le substrat, le substrat tissé comportant des fils de 22 décitex en chaîne et 33 en trame.

US 4 657 807 divulgue un procédé de métallisation d'un substrat en tissu par déposition en phase vapeur.

Les recherches de l'inventeur dans ce domaine l'ont conduit à étudier l'intérêt de l'application de la technique de métallisation, utilisée le plus généralement dans le domaine de l'emballage, pour revêtir des tissus.

Il est ainsi apparu qu'en traitant certains types de tissus avant de procéder à leur métallisation, il était possible d'obtenir un nouveau produit répondant aux qualités requises en particulier pour les applications ci-dessus.

L'invention a donc pour but de fournir un procédé d'élaboration de tissu métallisé qui présente notamment une texture agréable et une flexibilité améliorée tout en ayant des propriétés d'isolant thermique.

Elle vise également, en tant que produits nouveaux, les tissus obtenus ainsi que leurs applications.

Le procédé d'élaboration d'un tissu métallisé de l'invention est caractérisé en ce qu'il comprend les étapes de
- lavage d'un substrat tissé afin d'enlever la colle préalablement appliquée au tissu lors de sa fabrication
- éventuellement teinture ou impression du tissu
- calandrage du substrat par l'application d'un effort de compression sous forte température,
- métallisation sous vide du substrat par dépôt d'une couche de métal sous une atmosphère raréfiée,
le substrat tissé comportant des fils d'un poids maximal de 50 décitex, en chaîne comme en trame, avec un minimum de 30 filaments par fil.

L'utilisation de brins fins permet d'augmenter la brillance du substrat et d'ainsi augmenter la brillance du tissu métallisé. De manière préférée, on utilise un fil d'un poids de 50 décitex en chaîne et en trame comportant 36 filaments.

Les fils utilisés sont plats, ni texturés, ni tordus.

Les essais réalisés par l'inventeur ont montré que l'utilisation d'un substrat tissé appelé communément tissu était essentielle pour attendre les objectifs de souplesse recherchés.

De manière préférée, le substrat tissé, appelé également tissu, utilisé est à base de fibres synthétiques.

Le substrat tissé peut être à base de microfibres, c'est-à-dire de fibres présentant plus de 100 filaments par décitex ou de brins fins, c'est-à-dire de fibres proches de 100 filaments par décitex.

L'utilisation de fibres synthétiques permet de disposer d'un matériau pouvant fondre au moins partiellement, sans brûler. L'utilisation de microfibres ou de brins fins permet de conserver la souplesse du tissu.

Le tissage des fils est dense et très serré. De manière préférée le substrat tissé comprend au moins 42 fils de chaine et 40 fils de trame par centimètre. De manière plus préférée le substrat tissé comprend 44 fils de chaine et 41 fils de trame par centimètre.

L'étape de lavage du tissu est également appelée désencollage. En effet, selon les techniques habituelles de fabrication de tissus, un dépôt de colle est appliqué sur les fils avant leur tissage. Il convient, notamment pour conserver la souplesse du produit de supprimer cette colle.

De manière à obtenir un désencollage optimal, il est possible de réaliser deux passes de désencollage, en utilisant de la soude lors de l'une des deux passes.

Le calandrage s'effectue en une ou plusieurs passes successives sur une ou les deux faces du substrat lors desquelles un effort de compression est appliqué à chaud sur le tissu.

Une passe à 15m/minutes sur chaque face à une température de 195°C et un effort de 80 tonnes permet d'obtenir l'effet recherché.

L'objectif est d'évacuer une partie de l'air présent dans le tissu. On constate une pression sous vide 2,3 hPa (valeur supérieure à 0,24 hPa) est nécessaire pour permettre la réalisation de la phase métallisation. La contexture, c'est-à-dire l'ensemble des propriétés du tissu, et les traitements réalisés sur le tissu permettent de rester au dessous de cette valeur.

La phase de métallisation s'effectue sous vide à une vitesse de 420 m/minutes, notamment, par dépôt de métal en phase vapeur. Le métal déposé peut être par exemple de l'aluminium ou de l'argent.

On constate que les machines de métallisation généralement utilisées ne permettent pas de réaliser la métallisation de grandes longueurs de substrat. Le vide devient insuffisant et la machine se bloque.

Pour remédier à cela, il est nécessaire d'utiliser un procédé spécifique. Des bandes de 200 mètres de substrat sont alternées et mises bout à bout avec des bandes de 500 mètres de film polyester pour former une bande continue qui est introduite dans la machine de métallisation. De cette façon on évite un blocage de la machine par perte du vide. Lors du passage des bandes de films de polyester servant d'amorce, la vitesse de défilement et réduite à 180 mètres/minute afin de reconstituer le vide.

Il peut être nécessaire d'effectuer un ou plusieurs arrêts préventifs pour reconstituer le vide, lors du passage de la bande, pour éviter le blocage de la machine.

En alternative, il est possible d'utiliser une machine de métallisation spécifique, comportant plusieurs chambres de mise sous vide.

### Exemple 1 :

Un essai de dépôt sous vide a été réalisé. Le tissu à traiter se présente sous la forme d'une bande qui passe dans l'appareil de dépôt sous vide. Au fur et à mesure du passage de la bande de tissus, des mesures de la pression dans l'enceinte sous vide ont étés réalisées. On obtient les résultats suivants :
Le vide présent au départ avant le passage du tissu présente une pression de 0,32 hPa.

Après le passage de 500 m d'une bande de film polyester, on mesure une pression de 0,4 hPa.

Après le passage de 200 m de tissu après l'amorce on mesure une pression de 10 hPa.

Après le passage d'une deuxième bande de film polyester de 500 m, le vide s'est reconstitué à 0,59 hPa.

Par ailleurs on constate un disfonctionnement de l'appareil de dépôt sous vide lorsque le vide devient trop faible. Par conséquent dans le cas d'un tissu à base de microfibre texturée on cherchera à ne pas dépasser une pression de 40 hPa. Dans le cas d'un brin fin non texturé, on cherchera à ne pas dépasser une pression de 2.3 hPa.

### Exemple 2:

Des tests ont été réalisés par l'inventeur qui ont montré le caractère réalisable du procédé selon l'invention. Les caractéristiques du tissu utilisé sont précisées ci-après :
Le fil de chaîne comporte 100% de Polyester. Il s'agit d'un fil mi-mat plat comportant entre 44 et 50 filaments par décitex pour 43 fils/cm.
Le fil de trame comporte également 100% de Polyester. Il s'agit d'un fil mi-mat plat comportant entre 44 et 50 filaments par décitex pour 43 fils/cm.
L'armure est constituée d'une toile de type taffetas.

Les étapes du procédé sont ensuite mise en oeuvre de la façon suivante :
Le désencollage s'effectue par lavage à 85° C en milieu alcalin à PH 8/8.5 en utilisant des éléments tensioactifs et séquestrants selon une technique connue de l'homme du métier.
Le calandrage est ensuite réalisé à la vitesse de 15 mètres / minute sous 80 tonnes et à la température de 195°C.
Enfin la métallisation sous vide intervient à une pression maximum de 2.3 hPa.

## Revendications

1. Procédé d'élaboration d'un tissu métallisé, comprenant une étape de lavage d'un substrat tissé, **caractérisé en ce qu'**il comprend, après l'étape de lavage, les étapes suivantes :
- calandrage du substrat par l'application d'un effort de compression sur le substrat,
- métallisation sous vide du substrat, par dépôt de particules métalliques de manière à former une couche de métal sur le substrat, sous une atmosphère raréfiée,
le substrat tissé comportant des fils d'un poids maximal de 50 décitex en chaîne comme en trame, avec un minimum de 30 filaments par fil.

2. Procédé suivant la revendication 1, **caractérisé en ce que** le substrat comprend des fibres synthétiques.

3. Procédé suivant la revendication 1 ou 2, **caractérisé en ce que** le substrat comprend des microfibres.

4. Procédé suivant l'une quelconque des revendications précédentes, **caractérisé en ce que** le substrat tissé comprend au moins 42 fils de chaine et 40 fils de trame par centimètre.

5. Procédé suivant l'une quelconque des revendications précédentes, **caractérisé en ce que** le calandrage comporte au moins une passe pour chacune des faces du substrat.

6. Procédé suivant l'une quelconque des revendications précédentes, **caractérisé en ce que** la phase de métallisation s'effectue par dépôt de métal en phase vapeur.

7. Procédé suivant l'une quelconque des revendications précédentes, **caractérisé en ce que** le métal utilisé est l'aluminium.

8. Procédé suivant l'une quelconque des revendications précédentes, **caractérisé en ce que** lors de la phase de métallisation des bandes de substrat sont alternées et mises bout à bout avec des bandes de film pour former une bande continue qui est introduite dans la machine de métallisation.

9. Tissu métallisé susceptible d'être obtenu par l'application du procédé suivant l'une quelconque des revendications précédentes.

## Patentansprüche

1. Verfahren zur Herstellung eines metallisierten Gewebes, das einen Schritt des Waschens eines gewebten Substrats umfasst, **dadurch gekennzeichnet, dass** es nach dem Schritt des Waschens die folgenden Schritte umfasst:
- Kalandrieren des Substrats durch Anwendung einer Druckkraft auf das Substrat;
- Metallisierung des Substrats im Vakuum durch Abscheiden von Metallteilchen, so dass eine Metallschicht auf dem Substrat entsteht, unter niedrigem Druck;
wobei das gewebte Substrat Kett- sowie Schussfäden mit einem maximalen Titer von 50 Decitex und wenigstens 30 Filamenten pro Faden umfasst.

2. Verfahren gemäß Anspruch 1, **dadurch gekennzeichnet, dass** das Substrat synthetische Fasern umfasst.

3. Verfahren gemäß Anspruch 1 oder 2, **dadurch gekennzeichnet, dass** das Substrat Mikrofasern umfasst.

4. Verfahren gemäß einem der vorstehenden Ansprüche, **dadurch gekennzeichnet, dass** das gewebte Substrat wenigstens 42 Kettfäden und 40 Schussfäden pro Zentimeter umfasst.

5. Verfahren gemäß einem der vorstehenden Ansprüche, **dadurch gekennzeichnet, dass** das Kalandrieren jeweils wenigstens einen Durchgang pro Seite des Substrats umfasst.

6. Verfahren gemäß einem der vorstehenden Ansprüche, **dadurch gekennzeichnet, dass** der Metallisierungsschritt durch Abscheidung von Metall aus der Gasphase erfolgt.

7. Verfahren gemäß einem der vorstehenden Ansprüche, **dadurch gekennzeichnet, dass** das verwendete Metall Aluminium ist.

8. Verfahren gemäß einem der vorstehenden Ansprüche, **dadurch gekennzeichnet, dass** beim Metallisierungsschritt Substratbänder abwechselnd mit Folienbändern Stoß an Stoß gelegt werden, um ein Endlosband zu bilden, das in die Metallisierungsmaschine eingeführt wird.

9. Metallisiertes Gewebe, das durch Anwendung des Verfahrens gemäß einem der vorstehenden Ansprüche erhältlich ist.

## Claims

1. Method for producing a metalized fabric, the method comprising a step of washing a woven substrate, **characterized in that** it comprises, after the step of washing, the following steps:
- calendaring the substrate by applying a compressive force to the substrate;
- performing vacuum metallization on the substrate, by deposition of metal particles so as to form a layer of metal on the substrate, in a rarefied atmosphere,
the substrate comprising yarns having a weight of up to 50 decitex in the warp direction and in the weft or filling direction, with a minimum of 30 filaments by yarn.

2. Method according to claim 1, **characterized in that** the substrate comprises synthetic fibres.

3. Method according to claim 1 or 2, **characterized in that** the substrate comprises microfibers.

4. Method according to anyone the preceding claims, **characterized in that** the woven substrate comprises at least 42 warp yarns and 40 filling yarns per centimetre.

5. Method according to anyone the preceding claims, **characterized in that** calendaring the substrate comprises at least one pass for each side of the substrate.

6. Method according to anyone the preceding claims, **characterized in that** performing vacuum metallization includes performing metal vapour deposition.

7. Method according to anyone the preceding claims, **characterized in that** the formed layer of metal is aluminium.

8. Method according to anyone the preceding claims, **characterized in that**, during vacuum metallization, strips of substrate are alternated and placed end to end with strips of film to form a continuous strip that is introduced into the metallization machine.

9. Metalized fabric produced by implementing the method according to anyone the preceding claims.
